Europäisches Patentamt

European Patent Office

Office européen des brevets

(11) Veröffentlichungsnummer: **0 312 986**
**A1**

(12) **EUROPÄISCHE PATENTANMELDUNG**

(21) Anmeldenummer: 88117336.3

(51) Int. Cl.4: **H01L 21/90 , H01L 21/306**

(22) Anmeldetag: 18.10.88

(30) Priorität: 22.10.87 DE 3735813

(43) Veröffentlichungstag der Anmeldung:
26.04.89 Patentblatt 89/17

(84) Benannte Vertragsstaaten:
CH DE FR GB IT LI NL

(71) Anmelder: **Siemens Aktiengesellschaft Berlin und München**
**Wittelsbacherplatz 2**
**D-8000 München 2(DE)**

(72) Erfinder: **Higelin, Gerald. Dr.**
**Fasangartenstrasse 164**
**D-8000 München 90(DE)**
Erfinder: **Berthold, Jörg, Dr.**
**Echinger Strasse 11**
**D-8044 Lohhof(DE)**

(54) **Verfahren zum Rückätzen von Wolfram mit Titannitrid als Unterlage in Kontaktlöchern von höchstintegrierten Halbleiterschaltungen.**

(57) Für das Rückätzen von in Kontaktlöcher (6, 7) unterschiedlicher Tiefe in Isolationsschichten (5) eingebrachte Wolframschichten (10), die als Zwischenschicht zum Substrat (1, 2, 3, 4, 5) eine Doppelschicht (8, 9) aus Titan/Titannitrid enthalten, wird ein Plasmaätzprozeß in einer Einzelscheiben-Magnetron-Ätzanlage mit einem Fluor-Ionen und Sauerstoff enthaltenden Ätzgas verwendet und der Endpunkt der Ätzung auf der Titannitridschicht (9) durch Emissionsspektroskopie unter Verwendung der Wolframhexafluorid-Linie festgestellt. Durch den Plasmaätzprozeß wird eine hohe Selektivität von Wolfram (10) zu Titannitrid (9) von größer 30 : 1 erreicht; die Planarität liegt bei ± 7 %; es können Anordnungen mit extremer Grund-Topologie in VLSI-Technik hergestellt werden. Das Verfahren wird verwendet bei der Herstellung von CMOS-Schaltungen.

FIG 1

FIG 3

**Siemens Aktiengesellschaft**

Verfahren zum Rückätzen von Wolfram mit Titannitrid als Unterlage in Kontaktlöchern von höchstintegrierten Halbleitschaltungen.

Die Erfindung betrifft ein Verfahren zum Rückätzen der für die Auffüllung von unterschiedlich tiefen Kontaktlöchern in höchstintegrierten Silizium-Halbleiterschaltungen auf dem, die Kontaktlöcher in Isolationsschichten enthaltenden Substrat ganzflächig aufgebrachten Wolframschicht, welche als Zwischenschicht zum Substrat eine aus Titan/Titannitrid bestehende Unterlage enthält.

Bedingt durch die höhere Integration von Halbleiterschaltungen auf einem Chip nimmt der verfügbare Platz für das Einzelelement stetig ab. Bei der Verdrahtung von höchstintegrierten Halbleiterschaltkreisen wird daher zunehmend auch bei MOS-Schaltungen eine Mehrlagenverdrahtung notwendig. Voraussetzung dafür ist eine Planarisierung der Oberfläche der einzelnen Schichtkomponenten (Isolationsoxid, Metallisierungsschichten).

Eine Planarisierung läßt sich dadurch erreichen, daß man nach Öffnung der Kontakte eine geeignete Kontaktschicht bildet, darauf konform, zum Beispiel durch ein CVD-Verfahren (= chemical vapor deposition) Wolfram abscheidet und anschließend ganzflächig zurückätzt.

Folgende Anforderungen werden an die Kontaktschicht gestellt: sie muß einen niedrigen elektrischen Kontaktwiderstand zu $n^+$-, $p^+$-dotiertem Silizium und Siliziden zeigen, stabile Grenzflächen bei Temperaturlagerung aufweisen und gute Haftung zu Silizium und dotiertem Siliziumoxid haben. Das CVD-Wolfram muß eine gute Haftung auf dieser Kontaktschicht bei den angewandten Prozeßtemperaturen haben und mit diesem Material verträglich sein.

Die CVD-Wolframschicht wird nichtselektiv abgeschieden und deckt damit bis zum Rückätzprozeß die Vorderseite der Si-Scheiben ganzflächig ab. Um Partikel zu vermeiden und guten Kontakt zu darunter liegenden Strukturen zu gewährleisten, muß die CVD-Wolframschicht eine sehr gute Haftung auf der Kontaktschicht zeigen.

Bisher wurden als Haftschichten auf Silizium verwendet: aufgestäubte Schichten aus Titan, Titan/Wolfram und CVD-Schichten aus Wolframsilizid (siehe zum Beispiel Bericht von G. C. Smith und R. B. Jucha im Tagungsband Third International IEEE-VLSI Multilevel Interconnect Conference, Seiten 403 bis 410, IEEE Cat. Nr. 86CH2337-4, Santa Clara, CA, 09. - 10. Juni 1986).

Eine genügende Haftung von CVD-Wolfram auf Wolframsilizid läßt sich nur dadurch erreichen, daß Wolframsilizid durch einen Ätzprozeß aufgerauht wird; dies bedeutet, daß die Wolframsilizid-Schicht sehr dick sein muß, wodurch wegen der schlechten Kantenbedeckung die Auffüllung von Wolfram unvollständig wird.

Beim Rückätzprozeß von Wolfram als Kontaktlochfüller muß ein Ätzprozeß gewählt werden, der CVD-Wolfram selektiv zu der darunterliegenden Haftschicht ätzt. Nur so ist es möglich, daß eine Kontaktplanarisierung durchgeführt werden kann, wenn durch Topologieeffekte unterschiedlich tiefe Kontaktlöcher vorliegen.

Die obengenannten bekannten Haftschichten können nicht als Ätzstop dienen und sind daher nicht geeignet für eine Planarisierung von Kontaktlöchern unterschiedlicher Tiefe.

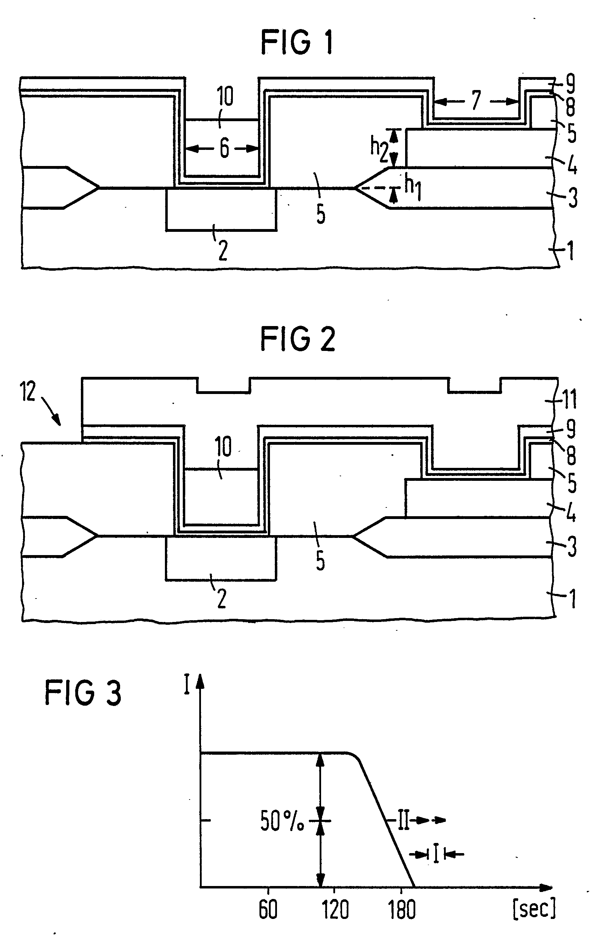

In der deutschen Patentanmeldung P 36 40 656.3 wird vorgeschlagen, als Kontaktschicht einen Aufbau aus Titan/Titannitrid zu verwenden. Auf diese, als Diffusionsbarriereschicht wirkende Titan/Titannitridschicht wird CVD-Wolfram abgeschieden bis das Kontaktloch sicher gefüllt ist und dann das Wolfram zusammen mit der Titan/Titannitrid-Doppelschicht zurückgeätzt, bis nur noch das Kontaktloch mit Wolfram gefüllt ist (siehe dort Figur 1). Der Vorteil dieses Schichtaufbaus ist, daß die Titanschicht sehr niedrige Kontaktwiderstände herstellt; die Titannitridschicht verhindert den direkten Kontakt von Wolfram sowie der bei der Abscheidung verwendeten Prozeßgase (Wolframhexafluorid) mit dem Siliziumsubstrat; außerdem stellt sie eine sehr gute Haftschicht für Wolfram dar.

Bei Vorhandensein unterschiedlich tiefer Kontaktlöcher durch vorhandene Topologie in unteren Ebenen lassen sich Rückätzverfahren wie bei planaren Strukturen nicht mehr anwenden. Um Inhomogenitäten in der Schichtdicke der CVD-Wolframschicht auszugleichen und an allen Stellen der Scheibe, an denen CVD-Wolfram entfernt werden soll, die CVD-Wolframschicht restfrei zu bekommen, ist es notwendig, den Rückätzprozeß zu überziehen. Dadurch ist gegeben, daß sehr flache Kontaktlöcher vollständig leer geätzt werden und das Ätzmedium den Kontaktlochboden erreichen kann. Wird die Titan/Titannitridschicht vom Ätzmedium angeätzt, so wird der Kontaktlochboden und die kontaktierten Schichten beschädigt.

Aufgabe der Erfindung ist es daher, ein Rückätzverfahren anzugeben, mit dem CVD-Wolfram als Kontaktlochfüller selektiv zu Titan/Titannitrid geätzt werden kann, so daß auch bei gleichem Ätzmittel das Titannitrid als Ätzstop dient.

Diese Aufgabe wird bei einem Verfahren der eingangs genannten Art dadurch gelöst, daß ein Plasmaätzprozeß in einer Einzelscheiben-Magnetronätzanlage in einem Fluor-Ionen und Sauerstoff enthaltenden Ätzgas durchgeführt wird und der Endpunkt der Ätzung als Ätzstop auf Titannitrid durch Emissionspektroskopie unter Verwendung einer Wellenlänge am Maximum des Emissionskontinuums festgestellt wird.

Weitere Ausgestaltungen der Erfindung ergeben sich aus Unteransprüchen.

Mit dem erfindungsgemäßen Verfahren lassen sich sehr zuverlässige Kontakte sowohl zwischen den Leitbahnebenen und dem Halbleitersubstrat als auch zwischen den verschiedenen Leitbahnebenen herstellen. Die hohe Zuverlässigkeit kommt dadurch zustande, daß die Schichten auf ein quasi ebenes Substrat aufgebracht werden. Da keine Schichtdickenabnahme im Kontaktloch bzw. via hole auftritt, ist die effektive Stromdichte an diesen Stellen geringer, so daß der Kontakt eine höhere Lebensdauer besitzt.

Das Verfahren nach der Lehre der Erfindung ist besonders geeignet zur Planarisierung von unterschiedlich tiefen Kontaktlöchern in Siliziumoxidschichten wie sie bei der Herstellung von komplementären MOS-Transistorschaltungen in VLSI-Technik (= very large scale integration) gefordert werden.

Weitere Einzelheiten der Erfindung werden nachfolgend anhand eines Ausführungsbeispiels und der Figuren 1 bis 3 noch näher erläutert. Dabei zeigen

die Figuren 1 und 2 im Schnittbild die erfindungswesentlichen Verfahrensschritte und
die Figur 3 in einem Diagramm den Kurvenverlauf des Signals für die Endpunkterkennung als Ätzstop auf Titannitrid.

Gleiche Teile sind in den Figuren mit gleichen Bezugszeichen bezeichnet.

Figur 1: Auf das mit dem Bezugszeichen 1 gekennzeichnete Siliziumsubstrat, in dem sich eine $n^+$- oder $p^+$-dotierte zu kontaktierende Zone 2 befindet und auf dem, auf dem Feldoxidbereich 3 eine Polysiliziumstruktur 4 angeordnet ist, wird eine als Isolationsschicht oder Zwischenoxid dienende Phosphor- und Bor-dotierte $SiO_2$-Schicht 5 aufgebracht, in die Kontaktlöcher 6 und 7 mit einem Durchmesser kleiner 1 $\mu$m im Bereich der dotierten Zone 2 und der Polysiliziumschichtstruktur 4 mit unterschiedlichen Kontaktlochtiefen eingeätzt werden.

Aus Figur 1 ist die Topologie der Unterlage mit den verschieden tiefen Kontaktlöchern 6 und 7 ersichtlich. Bedingt durch die Feldoxidbereiche 3 und die Polysiliziumschichtstruktur 4 ergeben sich bereits zwei Höhenunterschiede $h_1$ und $h_2$.

Nun wird auf die Anordnung (1 bis 7) nach kurzer Flußsäure-Vorbehandlung durch Kathodenzerstäubung zunächst eine 20 nm dicke Titanschicht 8 und darauf eine 100 nm dicke Titannitridschicht 9 aufgestäubt. Dann wird ohne direkte Vorbehandlung eine Wolframschicht 10 in einer Schichtdicke von 700 nm durch thermische Zersetzung von Wolframhexafluorid und Wasserstoff aufgebracht.

Beim Rückätzprozeß, bei dem das Wolfram von der Substratoberfläche (1, 5, 8, 9) wieder entfernt werden muß, wird ein Plasmaätzprozeß eingesetzt, der auf einer Magnetron-Einzelscheibenätzanlage, wie sie beispielsweise in der deutschen Patentanmeldung P 37 04 055.3 vorgeschlagen wird, durchgeführt wird. Bei den hier verwendeten Gasen handelt es sich um Schwefelhexafluorid ($SF_6$, Reinheit 99,99 %) und Sauerstoff ($O_2$, Reinheit 99,99 %). Die weiteren Parameter sind:
Druck in der Anlage 0.5 - 1.0 Pa
Gesamtfluß der Gase 70 sccm
Sauerstoff-Anteil 20 Vol-%
RF-Leistung 400 W
Ätzgeschwindigkeit 250 nm/min (kein loading-Effekt).

Die Selektivität Wolfram zu Titannitrid ist beim erfindungsgemäßen Prozeß größer 30 : 1 und der gesamte Ätzabtrag ist kleiner 10 nm bei einer Überätzzeit von 15 Prozent. Die festgestellte Uniformität ist besser als ± 7 %.

Figur 2: Nach dem Rückätzprozeß gemäß der Lehre der Erfindung wird nun die aus einer Aluminium/Silizium-Legierung bestehende Leiterbahn 11 aufgebracht, die zusammen mit der darunterliegenden Titan/Titannitridschicht 8, 9 strukturiert wird (siehe Pfeil 12).

Figur 3: Die Endpunkterkennung für den Rückätzprozeß erfolgt über Emissionsspektroskopie, die detektierte Wellenlänge liegt bei 576 nm (Maximum des Emissionskontinuums).

In Figur 3 ist als Abszisse die Ätzzeit in Sekunden, als Ordinate die Intensität J in willkürlichen Einheiten aufgetragen. Der Verlauf des Signals für die Endpunkterkennung als Ätzstop auf Titanntrid gilt für eine 700 nm dicke Wolframschicht. Wie aus dem Diagramm ersichtlich ist bleibt während der Rückätzung die Intensität konstant und fällt gegen Ende auf Null ab. Der Endpunkt der Ätzung (bei Restefreiheit) liegt in einem Endpunktintervall (siehe kleiner Doppelpfeil I) von ca. 15 Sekunden bis 30 Sekunden nach "Nullkontakt" der Plasmaintensität. Die Lage des Endpunktintervalls ist topographie-schichtdickenabhängig und muß mit Kontrollmessungen (optisches Mikroskop, Rasterelektronenmikroskop) vorher festgelegt werden.

Der am Abfall der Kurve auf Null eingezeichnete, nach rechts weisende Pfeil II kennzeichnet die Überätzzeit.

**Ansprüche**

1. Verfahren zum Rückätzen der für die Auffüllung von unterschiedlich tiefen Kontaktlöchern (6, 7) in höchstintegrierten Silizium-Halbleiterschaltungen auf dem die Kontaktlöcher (6, 7) in Isolationsschichten (5) enthaltenden Substrat (1, 2, 3, 4) ganzflächig aufgebrachten Wolframschicht (10), welche als Zwischenschicht (8, 9) zum Substrat eine aus Titan/Titannitrid bestehende Unterlage enthält, **dadurch gekennzeichnet,** daß ein Plasmaätzprozeß in einer Einzelscheiben-Magnetronätzanlage in einem Fluor-Ionen ·und Sauerstoff enthaltenden Ätzgas durchgeführt wird und der Endpunkt der Ätzung als Ätzstop auf Titannitrid (9) durch Emissionsspektroskopie unter Verwendung einer Wellenlänge am Maximum des Emissionskontinuums festgestellt wird.

2. Verfahren nach Anspruch 1, **dadurch gekennzeichnet,** daß als Ätzgas Schwefelhexafluorid (99,99 % Reinheit) und Sauerstoff (99,99 % Reinheit) mit einem Sauerstoffanteil von 20 Vol % verwendet wird.

3. Verfahren nach Anspruch 1 und 2, **dadurch gekennzeichnet,** daß der Druck in der Ätzanlage auf einen Bereich von 0.5 - 1.0 Pa, die Strömungsgeschwindigkeit der Gase auf einen Bereich von 70 sccm ( = Standard ccm) und die Hochfrequenzleistung auf 400 W eingestellt wird.

4. Verfahren nach einem der Ansprüche 1 bis 3, **dadurch gekennzeichnet,** daß die Ätzgeschwindigkeit auf 250 nm/min eingestellt wird.

5. Verfahren nach einem der Ansprüche 1 bis 4, **dadurch gekennzeichnet,** daß die rückzuätzende Wolframschicht (10) durch Abscheidung aus der Gasphase (CVD = chemical vapor deposition) erzeugt worden ist.

6. Verwendung des Verfahrens nach einem der Ansprüche 1 bis 5 zur Planarisierung von unterschiedlich tiefen Kontaktlöchern (6, 7) in insbesondere dotierten $SiO_2$-Isolationsschichten (5) bei der Herstellung von komplementären MOS-Transistorschaltungen.

# FIG 1

# FIG 2

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 169 082  (E.F.C.I.S.) <br> * Anspruch 5 * <br> --- | 1 | H 01 L 21/90 <br> H 01 L 21/306 |
| A | US-A-4 566 026  (LEE et al.) <br> * Spalte 2, Zeilen 50-55 * <br> --- | 1 | |
| A,D | 3rd INT. IEEE VLSI MULTILEVEL INTERCONNECT CONF., 9.-10. Juni 1986, Santa Clara, California, Seiten 403-410, IEEE,New York, US; G.C. SMITH et al.: "Comparison of two contact plug techniques for use with planarized oxide" <br> * Seite 406, Zeilen 1-15 * <br> ----- | 1 | |

RECHERCHIERTE SACHGEBIETE (Int. Cl.4)

H 01 L

Der vorliegende Recherchenbericht wurde für alle Patentansprüche erstellt

| Recherchenort | Abschlußdatum der Recherche | Prüfer |
|---|---|---|
| DEN HAAG | 19-12-1988 | PHEASANT N.J. |